# EUROPÄISCHE PATENTSCHRIFT

(11) **EP 0 358 649 B1**
(45) Veröffentlichungstag und Bekanntmachung des Hinweises auf die Patenterteilung: **14.12.1994**
(21) Anmeldenummer: 88903180.3
(22) Anmeldetag: 15.04.1988
(51) Int. Cl.: H03D 3/00

(54) **ANORDNUNG ZUM FILTERN EINES FM-EMPFANGSSIGNALS**
ARRANGEMENT FOR FILTERING AN INCOMING FM SIGNAL
AGENCEMENT DE FILTRAGE DE SIGNAUX DE RECEPTION A MODULATION DE FREQUENCE

(30) Priorität: 15.04.1987 DE 3712736; 24.07.1987 DE 3724604
(43) Veröffentlichungstag der Anmeldung: 21.03.1990
(73) Patentinhaber: H.U.C. ELEKTRONIK GMBH, D-13355 Berlin (DE)
(72) Erfinder: HANSEN, Jens, D-1000 Berlin 21 (DE)
(86) Internationale Anmeldenummer: DE8800236
(87) Internationale Veröffentlichungsnummer: WO8808223

(56) Entgegenhaltungen:
- EP-A- 0 048 661
- EP-A- 0 075 071
- WO-A-86/02505
- DE-A- 3 147 493
- FR-A- 2 497 039
- GB-A- 903 107

## Beschreibung

Die Erfindung betrifft eine Anordnung der im Oberbegriff des Anspruchs 1 angegebenen Art sowie einen FM-Empfänger, welcher mit einer derartigen Anordnung versehen ist.

Anordnungen dieser Art sind aus den DE-A-31 47 493 und 34 38 286, der EP-A1-75 071 oder der FR-A-81 21 986 bekannt, welche sämtlich auf den Erfinder zurückgehen.

Bei den heute gebräuchlichen FM-Empfängern -für Hörfunk ist ein breitbandiges ZF-Filter vorgesehen. Die Mittenfrequenz f_{ZF} eines derartigen breitbandigen ZF-Filters beträgt bei den meisten Standards 10,7 MHz, während die Kanalbandbreite etwa 200 kHz (± 100 kHz symmetrisch zur Mittenfrequenz f_{ZF}) ausmacht. Die Durchlaßkurve ist dabei so gewählt, daß ihre Bandbreite etwa der Übertragungsbandbreite entspricht. Infolge der großen Bandbreite werden relativ viele Stör- und Rauschanteile des Antenneneingangssignals von dem bekannten ZF-Filter durchgelassen, was zur Folge hat, daß relativ hohe Eingangsfeldstärken erforderlich sind, um ein empfangswürdiges Nutzsignal (Modulation) zu gewährleisten.

Zur Erhöhung der Empfangsempfindlichkeit ist es aus den oben genannten Druckschriften bekannt, als ZF-Filter ein in Bezug auf die Kanalbandbreite schmalbandiges Filter zu verwenden. Die Mittenfrequenz dieses schmalbandigen ZF-Filters wird in Abhängigkeit von der Modulation des Empfangssignals nachgesteuert. Zu jedem beliebigen Zeitpunkt wird damit exakt dort selektiert, wo sich gerade die Momentan-ZF befindet. Hierdurch ergibt sich eine wesentlich verbesserte Unterdrückung von Stör- und Rauschanteilen. Die Bandbreite dieses gesteuerten ZF-Filters, das auch als "In-Channel-Select"-Filter oder abgekürzt "ICS"-Filter in der Literatur bezeichnet wird, beträgt etwa 20 kHz, wodurch allerdings nur der monofone Nutzsignalanteil (L+R-Komponente des MPX-Nutzsignals) durchgelassen wird.

Aus diesem Grund ist es bei einem Stereo-FM-Empfänger bisher nur möglich, das ICS-Filter parallel zu einem breitbandigen ZF-Filter zu betreiben und wirksam auf die NF-Stufe des Empfängers zu schalten, wenn aufgrund eines zu schwachen oder zu sehr gestörten Empfangssignals (etwa unterhalb 25 µV Antennen-Eingangsspannung) ohnehin nur eine monofone Wiedergabe möglich ist.

Die Aufgabe der Erfindung besteht demgegenüber darin, bei einer Filteranordnung der eingangs erwähnten Art eine Filterung des gesamten Signals mit ausreichender Empfindlichkeit und Störsicherheit ohne wesentlich erhöhten baulichen Aufwand zu erreichen.

Diese Aufgabe wird erfindungsgemäß durch die kennzeichnenden Merkmale des Patentanspruchs 1 gelöst.

Die Vorteile der Erfindung bestehen überraschenderweise aber nicht nur in einer Verbesserung des Übertragungsverhaltens für FM-Stereo-Signale. Es hat sich gezeigt, daß sich durch den gefundenen Verlauf der Übertragungscharakteristik viele Verbesserungen für die Eigenschaften des ICS-Verfahrens allgemein gewinnen lassen. Durch die Anpassung der Durchlaßkurve in Abhängigkeit von den Signalbedingungen eine wesentliche Verbesserung der Empfangsverhältnisse unter kritischen Bedingungen erzielt.

Insoweit ist die erfindungsgemäße Schaltung auch solchen Lösungen weit überlegen, welche - wie beispielsweise in der GB 903 401 beschrieben - ausschließlich von einer Änderung der Filterbandbreite Gebrauch machen.

Vorteilhafte Ausgestaltungen der erfindungsgmäßen Filterordnung ergeben sich aus den Unteransprüchen.

Hierbei ist auch ein mit der erfindungsgemäßen Filteranordnung ausgerüsteter FM-Stereo-Empfänger mit seinen Merkmalen in vorteilhafter Weiterbildung sowie eine Schaltung zur Nachbarkanalerkennung angegeben.

Die Erfindung beruht auf der Erkenntnis, daß die mit dem ICS-Verfahren verbundene Verbesserung insbesondere dann günstig genutzt werden kann, wenn in kritischen Empfangsituationen auf einen schmalbandigeren Verlauf des Durchlaßverhaltens umgeschaltet wird. Trotz nahe beim Nutzsignal gelegener Störungen werden diese dadurch besonders wirksam ausgeschaltet, daß die nachführbaren Filter der Nutzmodulation unmittelbar folgen. Es lassen sich damit also solche Störsignale wirksam beseitigen, welche durch die Anwendung des ICS-Verfahrens oder einer Bandbreitenumschaltung jeweils allein in ihren Auswirkungen kaum zu vermindern gewesen wären. Erst durch die Summe der erfindungsgemäßen Maßnahmen werden sie in ihren Auswirkungen soweit herabgesetzt, daß sie nurmehr mit meßtechnischen Mitteln wahrnehmbar sind.

Besonders vorteilhaft bei der Erfindung ist, daß durch die Änderung der Übertragungscharakteristik eine Anpassung an die aktuelle Empfangssituation in solcher Weise erfolgt, daß die die Hörqualität kaum nachteilig beeinflußt ist. Es wird trotz einer relativ dramatischen Beeinträchtigung der Empfangsqualität insbesondere durch Störquellen in der Nähe des Nutzsignals dafür gesorgt, daß - insbesondere in einer mobilen Empfangssituation - keine subjektiv bemerkbare Empfangsverschlechterung eintritt. Dieser Erfolg ist insbesondere deswegen von besonderer Bedeutung, als plötzlich einsetzende kurzzeitige starke Geräusche den Hörgenuß bezüglich der gesamten Darbietung verleiden, auch wenn der weitaus größte Teil der übertragenen Passagen von ausgezeichneter Übertragungsqualität ist.

Eine bevorzugte Ausführung einer Schaltung zur Erkennung von Nachbarkanalstörungen bildet ein wirksames Mittel zur Beurteilung der Empfangsqualität um in Abhängigkeit vom Ausgangssignal dieser Schaltung das Durchlaßverhalten selbsttätig zu verändern. Insbesondere wird die Durchlaßkurve schmalbandiger, wenn Nachbarkanalstörungen erkannt werden.

Die Erfindung wird anhand der Zeichnungen näher beschrieben. Es zeigen :
- Fig. 1: Durchlaßkurven der erfindungsgemäßen Schaltung,
- Fig. 2: ein Blockshaltbild der erfindungsgemäßen Shaltung,
- Fig. 3: Durchlaßkurven der Filter aus Fig. 2,
- Fig. 4: Phasengänge am Ausgang des Demodulators aus Fig. 2 und
- Fig. 5a bis 5e: eine Schaltung zur Nachbarkanalstörungen sowie darin auftretende Signale.

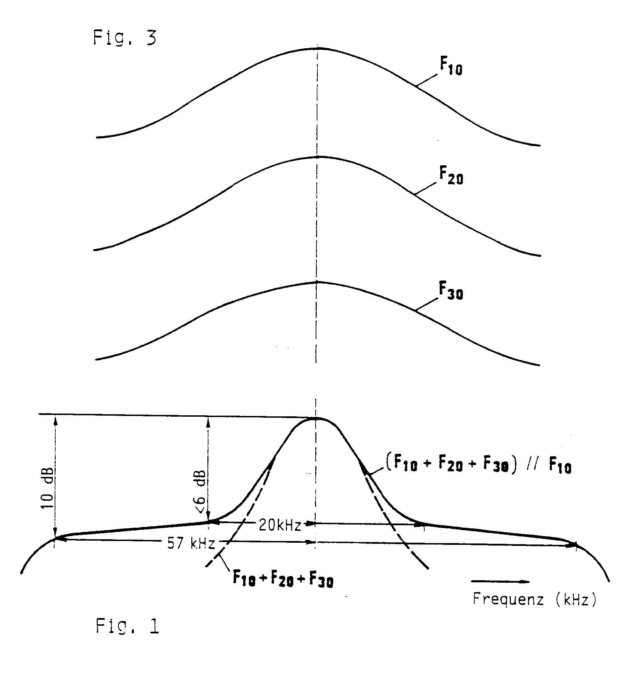

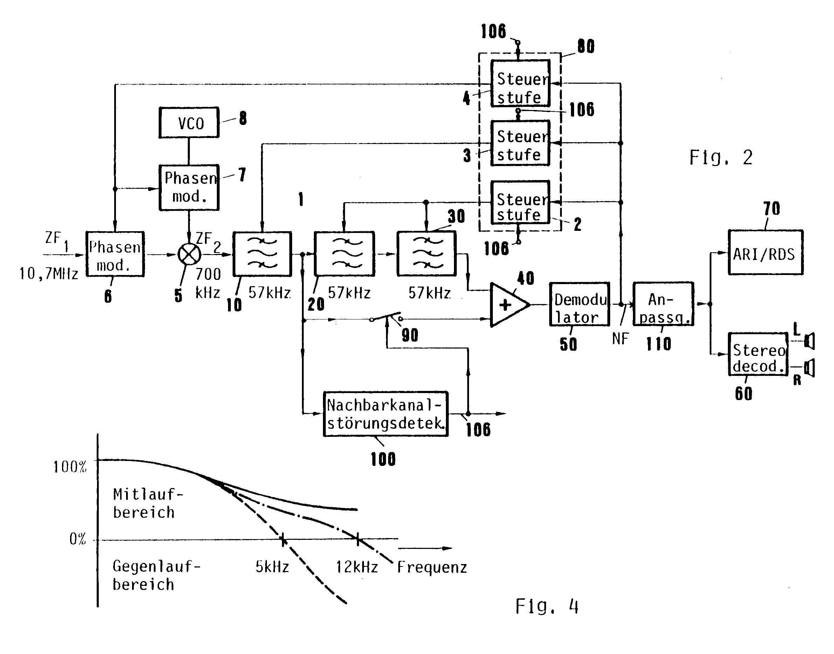

Die Durchlaßkurve gemäβ Figur 1, auf die weiter unten näher eingegangen werden wird, betrifft das Durchlaßverhalten des in Figur 2 als Ausführungsbeispiel gezeigten erfindungsgemäßen FM-Stereo-Empfängers. Dieser ist ohne Vor- und Mischstufe dargestellt, so daß als Eingangssignal der gezeigten Blockschaltung ein normgerechtes ZF-Signal ZF₁ mit einer Frequenz von 10,7 MHz vorliegt.

Wesentlicher Bestandteil der Blockschaltung nach Figur 2 ist die erfindungsgemäße ZF-Filteranordnung 1, welche in einem ersten, oberen Filterzweig drei in Serie angeordnete Filterstufen 10, 20 und 30 aufweist. Entsprechend der Bandbreite des MPX-Signals von 57 kHz weist die Filterstufe 10, welche den relativ ebenen Kurvenabschnitt der Filterdurchlaßkurve gemäß Figur 1 bestimmt und über welche die höherfrequenten Anteile des MPX-Signals gelangen, eine Bandbreite von ±57 kHz, also ungefähr 100 kHz auf. Bei einer günstigen Ausführungsvariante handelt es sich bei dem Filter 10 nicht - wie es in Figur 3 dem durchgezogenen Verlauf des Übertragungsverhaltens (auch der anderen Filter) entspricht - um ein Einzelkreisfilter, sondern um ein zweipoliges Bandfilter. Der in diesem Fall ebenere Verlauf der Durchlaßkurve dieses Filters ist in Figur 3 mit F_{10′} bezeichnet und gestrichelt dargestellt. Die Bandbreiten der Filterstufen 20 und 30 sind so bemessen, daß die Bandbreite der Serienschaltung der Filterstufen 10, 20, 30 etwa 20 kHz beträgt.

Bei dem betrachteten MPX-Signal ("MPX" = Multiplex) handelt es sich in erster Linie um ein heute übliches analoges FM-Stereo-Rundfunksignal. Es ist jedoch ohne weiteres möglich, ein digitales FM-Stereo-Rundfunksignal mit Hilfe dieser Filteranordnung zu verarbeiten.

Durch die Serienschaltung der drei Filterstufen 10, 20, 30 ergibt sich der in Figur 1 teilweise gestrichelt angedeutete schmalbandigere Frequenzverlauf F₁₀+F₂₀+F₃₀.

Dieser schmale, steilflankige Verlauf wird dem Verlauf der Durchlaßkurve F₁₀ überlagert, woraus sich der in Figur 1 mit durchgezogener Linie gezeichnete Verlauf der untersten Kurve ergibt. Diese Überlagerung erfolgt schaltungstechnisch dadurch, daß der Ausgang der ersten Filterstufe 10 in einem zweiten Filterzweig der Filteranordnung 1 einer Addierstufe 40 zugeführt wird, welche ferner mit dem Ausgang der dritten Filterstufe 30 verbunden ist. Bei der Addierstufe 40 handelt es sich zweckmäßigerweise um einen Summierverstärker, welcher das gefilterte ZF-Signal auf den erforderlichen Pegel verstärkt, der für die anschließende Demodulation im Demodulator 50 benötigt wird. Eine in dieser Weise realisierte Filterdurchlaßcharakteristik kann, ohne vom Erfindungsgedanken abzuweisen, auch auf andere Weise, z.B. mittels digitaler Filter schaltungstechnisch verwirklicht werden.

Das demodulierte, mit "NF" bezeichnete Signal am Ausgang des Demodulators 50 wird mittels einer Korrekturstufe 110 einer Pegel- und ggfs. Phasenkorrektur unterzogen, um die unterschiedlichen Pegel- und Phasenverläufe in den beiden Filterzweigen, sprich: der beiden Eingangssignale der Addierstufe 40, auszugleichen. Das korrigierte NF-Signal, das sämtliche Komponenten des MPX-Signals enthält, wird einem Stereodecoder 60 sowie einer ARI/RDS-Stufe 70 zugeführt.

Der Stereodecoder 60 erzeugt aus den L+R- und L-R-Komponenten die stereofonen Links (L)-und Rechts (R)- Informationen, die entsprechenden L- bzw. R-Kanälen zugeführt werden. Die ARI/RDS-Stufe siebt den modulierten 57 kHz-Hilfsträger des ARI- und/oder RDS-Signals schmalbandig aus, demoduliert und (im Falle von RDS) decodiert das ARI- bzw. RDS-Zusatzsignal und wertet diese Zusatzsignale aus. Die Steuerstufe 80 erzeugt aus dem NF-Signal (=Modulation) am Ausgang des Demodulators 50 ein Mitkopplungs-Steuersignal St, welches den Steuereingängen aller Filterstufen zugeführt wird. Unter ARI-Zusatzsignal wird eine Auto-Radio-Information in Form einer Verkehrsfunksender- und -bereichskennung verstanden, welche in Amplitudenmodulation dem 57 kHz-Hilfsträger aufmoduliert ist. Unter RDS-Zusatzsignal wird eine Radio-Daten-System-Information verstanden, welche zusätzlich oder unabhängig von dem ARI-Zusatzsignal in Form eines digitalen Signals in 2PSK-Modulation dem 57 kHz-Hilfsträger in Quadraturvorlage aufmoduliert ist. Die RDS-Information enthält neben der Verkehrsfunksendererkennung eine Senderidentifikation, eine Programmarterkennung sowie die dasselbe Programm wie der eingestellte Sender ausstrahlenden alternativen Frequenzen (vgl. EBU Doc. Tech. 3244 der Europäischen Rundfunk-Union).

Des weiteren wird das NF-Signal vor oder nach der Korrektur der Steuerstufe 80 zugeführt, welche in noch näher zu erläuternder Weise die Filterstufen 10, 20 und 30 in Abhängigkeit von der Modulation auf die Momentan-ZF nachsteuert.

Zunächst soll nochmals die unterste Kurve in Fig. 3 betrachtet werden. Die in Fig. 3 mit F₁₀+F₂₀+F₃₀ bezeichnete Filterkurve weist im Bereich der auf die Momentan-ZF nachgesteuerten Mittenfrequenz f_{ZF} eine scharfe Filterabsenkung von wenigstens 6 dB bei einer Breite von ca. 20 kHz auf. Diese scharfe Filterabsenkung resultiert, wie schon erwähnt, aus der Hintereinanderschaltung der Filterstufen 10, 20 und 30. Bei einer Überlagerung des Durchlaßbereichs der Summenkurve F₁₀+F₂₀+F₃₀ mit dem flachen Durchlaßbereich der Kurve F₁₀ in der Addierstufe 4 werden die den Durchlaßbereichen zugeordneten Signalpegel so eingestellt, daß der resultierende Durchlaßbereich der Kurve 2F₁₀+F₂₀+F₃₀ in seinem Resonanzpunkt etwa 10 dB oberhalb des Durchlaßbereichs der Kurve F₁₀ liegt. Damit entstehen relativ eben verlaufende Kurvenäste in einem symmetrisch von der Kanalmitte (=f_{ZF}) um etwa 38 kHz entfernten Bereich, welche ausreichend sind für eine wirksame Rausch- und Störunterdrückung des L-R-Bandes im MPX-Signal. Die Durchlaßgrenzen der Gesamtkurve (F₁₀+F₂₀+F₃₀)/F₁₀ liegen etwa 57 kHz von der Kanalmitte entfernt, so daß auch der 57 kHz-Hilfsträger im MPX-Signal wirksam gefiltert wird.

In dem zweiten Filterzweig der Filteranordnung 1 (Fig. 2) ist ein elektronischer Schalter 90 vorgesehen, welcher von einer Stufe 100 zur Erkennung von Nachbarkanalstörungen gesteuert wird. Die Stufe 100 wird im dargestellten Beispielsfall vom dem Ausgang der ersten Filterstufe gespeist und weist eine Schaltschwelle auf, oberhalb welcher dem Schalter 90 ein Schaltsignal zugeführt wird. Falls nämlich die Nachbarkanalstörungen einen Grenzwert übersteigen, ist eine Stereowidergabe nicht mehr sinnvoll, so daß über den Schalter 90 die erwähnte Überlagerung der schmalen, steilflankigen Kurve F₁₀+F₂₀+F₃₀ (Fig. 3) mit der flachen Kurve F₁₀ unterbunden wird und damit nur noch die erwähnte schmale, steilflankige Kurve für die Filterung des ZF-Signals wirksam wird, allerdings nur für eine monofone Signalwidergabe. Das in diesem Fall resultierende ZF-Signal am Ausgang der Addierstufe 40 weist eine höhere Selektivität als im Falle eines geschlossenen Schalters 90 auf, wodurch die detektierten Nachbarkanalstörungen ausgeblendet werden und ein störungsfreier Mono-Empfang gesichert ist.

Die durch den Schalter 90 bewirkte Mono/Stereo-Umschaltung ermöglicht es u.U., auf den heute üblichen Mono-Stereo-Umschalter im Stereodecoder 60 zu verzichten.

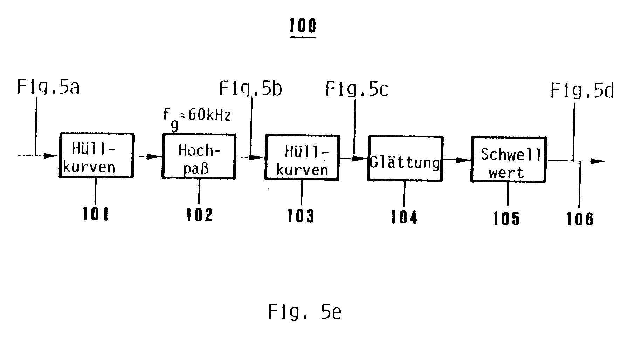

Die in Fig. 5e näher dargestellte Stufe 100 besteht aus der Serienschaltung
- eines ersten Hüllkurvendemodulators 101,
- eines Hochpaßfilters 102 mit einer Großfrequenz von etwa 60 kHz,
- eines zweiten Hüllkurvendemodulators 103;
- einer Glättungsstufe 104, und
- einer Schwellwert-Schaltstufe 105.

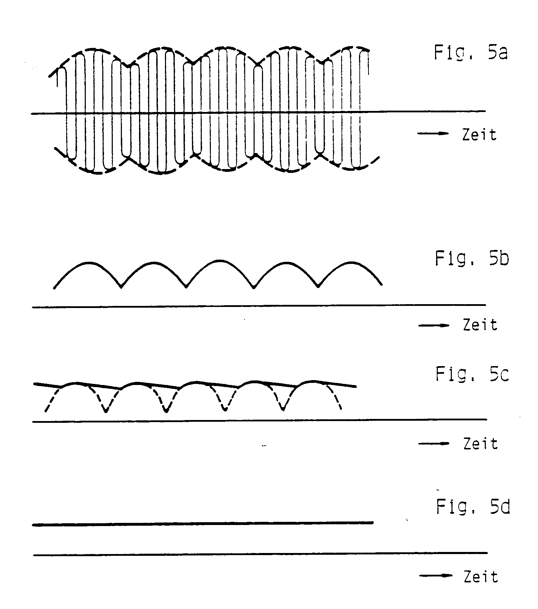

Dem Hüllkurvendemodulator 101 wird das in Fig. 5a veranschaulichte Ausgangssignal der ersten Filterstufe 10 zugeführt, welches durch Interferenzen zwischen Nutz- und Nachbarkanal in der Amplitude moduliert ist. Je stärker der Nachbarkanalträger ist, desto größer ist diese Amplitudenmodulation. Das demodulierte Interferenzsignal (Fig. 5b) am Ausgang des Hüllkurvendemodulators 101 wird mittels eines Hoch- und/oder Tiefpaßfilters 102 von niederfrequenten Signalanteilen, die von der Nutzmodulation herrühren bzw. höherfrequenten Störanteilen befreit. In dem anschließenden zweiten Hüllkurvendemodulator 103 wird über das demodulierte, hochpaßgefilterte Interferenzsignal die Hüllkurve (Fig. 5c) gebildet, welche mittels der Stufe 104 geglättet wird und in der Schwellwert-Schaltstufe 105 mit einem vorgegebenen Referenzpegel verglichen wird. Überschreitet das geglättete Hüllkurvensignal den Referenzpegel, so erzeugt die Schaltstufe 105 an ihrem Ausgang 106 das in Fig. 5d gezeigte Schaltsignal. Dieses Schaltsignal wird, wie in Fig. 4 durch die mit "106" markierten Eingänge der Stufen 2, 3 und 4 angedeutet ist, den Steuerstufen 2, 3 und 4 zugeführt, ferner dem Steuereingang des Schalters 90. In den Steuerstufen 2 und 3 bewirkt das Schaltsigal eine leichte Absenkung der Frequenzanteile der dort gezeigten Steuerspannungen etwa oberhalb 6 kHz. Dagegen bewirkt das Schaltsignal in der Steuerstufe 4 für die Phasenmodulatoren 6, 7 eine leichte Anhebung der Frequenzanteile der dort erzeugten Steuerspannung etwa oberhalb 5 kHz. Diese Frequenzgangbeeinflussungen sind deshalb erforderlich, weil infolge der geänderten Gesamtfiltercharakteristik der gesteuerten ZF-Filterstufen 10, 20, 30 die Phasensteilheit erhöht wird, was ohne die erwähnte Frequenzgangbeeinflussung zu einer erhöhten Störphasenmodulation im höheren Frequenzbereich oberhalb etwa 5 kHz führen würde.

Im folgenden soll auf die Nachsteuerung der Filterstufen 10, 20 und 30 näher eingegangen werden. Hierzu sind in Fig. 4 drei verschiedene Phasengänge des NF-Signals am Ausgang des Demodulators gezeigt, wobei mit durchgezogener Linie der erfindungsgemäß erzielte Phasengang angedeutet ist. Infolge der Nachsteuerung der Filterstufen mit dem NF-Signal bzw. einem daraus abgeleiteten Steuersignal tritt ein mit zunehmender NF-Signalfrequenz steigender Phasenwinkel zwischen ZF-Signal und Steuersignal auf. Ohne die nachstehend beschriebenen Maßnahmen würde dieser Phasenwinkel bei etwa 5 kHz so groß werden, daß aus der bis dahin wirksamen Mitkopplung (in Fig. 4 als "Mitlaufbereich" bezeichnet) eine Gegenkopplung ("Gegenlaufbereich") wird.

Da man den erwähnten Phasenwinkel als Phasenmodulation des ZF-Signals verstehen kann, hatte der Erfinder bereits früher die Idee (DE-A-31 47 493), das ZF-Signal vor der Filterung durch die Filterstufen 10, 20, 30 einer entgegengesetzten Phasenmodulation zu unterwerfen. Hierzu wird, wie aus Fig. 2 ersichtlich ist, in einer ersten Steuerstufe 2 ein nachsteuerndes erstes Steuersignal für die Filterstufen 20 und 30 erzeugt und in einer zweiten Steuerstufe 3 ein zweites Steuersignal für die erste Filterstufe 10 als Phasenmodulator wirksam ist. Mit Hilfe dieser Phasenmodulation läßt sich der in Fig. 4 gestrichelt eingezeichnete Phasengang mit Nullstelle bei 5kHz in Richtung höherer Frequenzen verschieben (strichpunktiert eingezeichneter Phasengang), so daß sich eine Nullstelle, d.h. ein Wechsel vom erwünschten Mitlaufbereich in den unerwünschten Gegenlaufbereich, bei etwa 12 kHz einstellt, so daß diese Maßnahme noch nicht befriedigen kann.

Bei dem Empfänger nach Fig. 2 sind zwei weitere Phasenmodulatoren 6 und 7 vorgesehen, welche von einer dritten Steuerstufe 4 gemeinsam angesteuert werden. Der Phasenmodulator 6 ist vor einer Mischstufe 5 angeordnet, welche das ankommende Norm-ZF-Signal ZF₁ von 10,7 MHz in ein z weites ZF-Signal ZF₂ von z.B. 700 kHz umsetzt. Hierzu dient ein Lokaloszillator 8, dem der dritte Phasenmodulator 7 nachgeschaltet ist. Die Steuersignale der Steuerstufen 2, 3 und 4 sowie die Frequenzgänge der Phasenmodulatoren 8, 7 und 10 sind derart aufeinander abgestimmt, daß sich der in Fig. 4 mit durchgezogener Linie gezeigte Phasengang des NF-Signals am Ausgang des Demodulators 50 ergibt, welcher auch bei höheren NF-Frequenzen im Mitlaufbereich verbleibt.

Mit Hilfe der Erfindung ist es erstmals und in überraschender Weise möglich, ein MPX-Signal mit erheblich vergrößerter Empfindlichkeit zu empfangen und bis herab auf etwa 8 µV Antenneneingangsspannung stereofon wiederzugeben. Dabei ist der Filteraufwand nicht größer als bisher für die reine Mono-Lösung.

## Patentansprüche

1. Anordnung zum Filtern eines FM-Empfangssignals, insbesondere beim mobilen Empfang, bei welcher die Mittenfrequenz eines bezüglich der Kanalbandbreite relativ schmalbandigen ZF-Filters in Abhängigkeit von der Modulation kontinuierlich unmittelbar nachgesteuert wird,
**dadurch gekennzeichnet**,
daß die Form der Durchlaßkurve des nachgesteuerten ZF-Filters (1) veränderbar ist, indem der Durchlaßbereich in Abhängigkeit von einer Schaltung (100), deren Ausgangssignal ein Maß für die Empfangsqualität bildet, mit abnehmender Signalqualität schmalbandiger geschaltet wird, wobei ein erster Filterzweig des ZF-Filters (1) ständig vom FM-Empfangssignal durchlaufen wird.

2. Vorrichtung nach Anspruch 1, **dadurch** **gekennzeichnet**, daß für die Empfangsqualität ein Grenzwert vorgegeben ist, bei dessen Unterschreitung der Durchlaßbereich schmalbandiger geschaltet wird.

3. Anordnung nach Anspruch 1, **dadurch** **gekennzeichnet**, daß die Schaltung, deren Ausgangssignal ein Maß für die Empfangsqualität bildet, durch eine Schaltung für die Nachbarkanalerkennung gebildet wird.

4. Anordnung nach Anspruch 3, **dadurch** **gekennzeichnet**, daß die Schaltung zur Nachbarkanalerkennung eine Serienschaltung aus folgenden Baustufen aufweist:
- einen erster Hüllkurvendemodulator (101), welchem das durch Interferenzen zwischen Nutz- und Nachbarkanal in der Amplitude modulierte Ausgangssignal der ersten Filterstufe (10) zugeführt wird;
- ein Hoch- und/oder Tiefpaßfilter (102), welches das demodulierte Interferenzsignal am Ausgang des ersten Hüllkurvendemodulators (101) von hoch- oder niederfrequenten Signalanteilen trennt;
- einen zweiten Hüllkurvendemodulator (103), welcher über das demodulierte, hochpaßgefilterte Interferenzsignal die Hüllkurve bildet, deren Pegel ein Maß für den Pegel des Nachbarkanalträgers darstellt, und
- eine Schwellwert-Schaltstufe (105), welche das gegebenenfalls geglättete (Glättungsstufe 104) Hüllkurvensignal mit einem vorgegebenen Referenzpegel vergleicht und bei Überschreiten des Referenzpegels ein Schaltsignal abgibt.

5. Anordnung nach einem der vorangehenden Ansprüche, **dadurch gekennzeichnet**, daß das nachgesteuerte ZF-Filter (1) wenigstens zwei hintereinander angeordnete Filterstufen (10, 20, 30) aufweist, wobei die Ausgangssignale zweier Filterstufen (10) additiv verknüpfbar sind und das verknüpfte, einen breiteren Frequenzbereich aufweisendes Signal einer nachfolgenden Demodulationsstufe zugeleitet wird.

6. Anordnung nach Anspruch 5, **dadurch gekennzeichnet**, daß es sich bei mindestens einer der Filterstufen, deren Ausgangsignal additiv verknüpfbar ist, um ein Bandfilter mit relativ breiter Durchlaßcharakteristik handelt.

7. Anordnung nach Anspruch 5, **dadurch gekennzeichnet**, daß es sich bei mindestens einer der Filterstufen, deren Ausgangssignal additiv verknüpfbar ist, um ein Einzelkreisfilter mit relativ schmaler Durchlaßcharakteristik handelt.

8. Anordnung nach Anspruch 7, **dadurch gekennzeichnet**, daß zwei hintereinandergeschaltete, auf die gleiche Frequenz abgestimmte Einzelkreisfilter vorgesehen sind.

9. FM-Empfänger mit einer als ZF-Filter vorgesehenen anordnung gemäß Anspruch 1, einem dem ZF-Filter nachgeschalteten Demodulator, **dadurch gekennzeichnet**, daß nach dem Demodulator (50) eine Korrekturstufe (110) angeordnet ist, die so ausgebildet ist, daß das die durch unterschiedliche Gruppenlaufzeiten und Pegel der additiv verknüpften Filterstufen entstehenden unterschiedlichen Phasenverläufe und Pegel in dem Niederfrequenzbereich ausgeglichen werden.

10. FM-Empfänger nach Anspruch 9, **dadurch gekennzeichnet**, daß
- die Steuerspannung (Steuerstufen 2, 3) für die nachgesteuerten ZF-Filterstufen (10, 20, 30) im Frequenzgang derart beeinflußt wird, daß die Frequenzanteile etwa oberhalb 6 kHz leicht abgesenkt werden, und
- die Steuerspannung des zweiten und dritten Phasenmodulators (6, 7) im Frequenzgang derart beeinflußt wird, daß die hohen Frequenzanteile etwa ab 5 kHz leicht angehoben werden.

11. Anordnung nach einem der Ansprüche 5 bis 10, **dadurch** **gekennzeichnet**, daß innerhalb des ZF-Filters ein zweiter, die zweite und gegebenenfalls weitere vorhandene Filterstufen (20, 30) überbrückender Filterzweig mit einem Schalter (90) vorgesehen ist, der in Abhängigkeit vom Ausgangssignal der Schaltung (100), deren Ausgangssignal ein Maß für die Empfangsqualität bildet, ein- oder ausgeschaltet ist.

12. Anordnung nach Anspruch 11 , **dadurch** **gekennzeichnet**, daß der erste und der zweite Filterzweig in eine dem Demodulator (50) vorgeschaltete Addierstufe (40) münden, in der die sie durchlaufenden Signale aufsummiert werden.

## Claims

1. Arrangement for filtering a received FM signal, particularly in the case of mobile reception, in which the centre frequency of an intermediate frequency filter which is relatively narrow-band as regards the channel bandwidth is continuousJy directly adjusted as a function of the modulation, characterised in that the shape of the selectivity curve of the adjusted intermediate frequency filter (1) is variable, in that with decreasing signal quality the bandpass range is switched to a narrower band in dependence on the output of a circuit (100), the output signal of which forms a measurement for the reception quality, wherein the received FM signal constantly runs through a first filter branch of the intermediate frequency filter (1).

2. Device according to Claim 1, characterised in that a boundary value is predetermined for the reception quality, and when the quality falls below this boundary value the band-pass range is switched to a narrower band.

3. Arrangement according to Claim 1, characterised in that the circuit whereof the output signal forms a measurement for the reception quality is formed by a circuit for adjacent channel recognition.

4. Arrangement according to Claim 3, characterised in that the circuit for adjacent channel recognition has a series connection of the following component stages:
- a first envelope curve demodulator (101) to which is supplied the output signal from the first filter stage (10), which output signal is modulated in amplitude by interferences between the useful and adjacent channels;
- a high and/or low pass filter (102) which separates the demodulated interference signal at the output of the first envelope curve demodulator (101) from high or low frequency signal components;
- a second envelope curve demodulator (103), which by way of the demodulated high-pass filtered interference signal forms the interference curve the level of which represents a measurement for the level of the adjacent channel carrier, and
- a threshold value switching stage (105) which compares the envelope curve signal, which has optionally been smoothed (smoothing stage 104), with a predetermined reference level and emits a switching signal when the reference level is exceeded.

5. Arrangement according to one of the preceding claims, characterised in that the adjusted intermediate frequency filter (1) has at least two filter stages (10, 20, 30) arranged one behind another, wherein the output signals of two filter stages (10) can be combined by addition and the combined signal having a wider frequency range is passed to a subsequent demodulation stage.

6. Arrangement according to Claim 5, characterised in that at least one of the filter stages whereof the output signals can be combined by addition is a band filter with a relatively wide pass characteristic.

7. Arrangement according to Claim 5, characterised in that at least one of the filter stages whereof the output signals can be combined by addition is a single-circuit filter with a relatively narrow pass characteristic.

8. Arrangement according to Claim 7, characterised in that two single-circuit filters are provided which are arranged behind one another and tuned to the same frequency.

9. FM receiver with an arrangement according to Claim 1 provided as an intermediate frequency filter, and a demodulator arranged after the intermediate frequency filter, characterised in that after the demodulator (50) there is disposed a correction stage (110) which is so constructed that the different phase developments and levels resulting from different group delays and levels of the filter stages combined by addition are equalised in the low frequency range.

10. FM receiver according to Claim 9, characterised in that
- the control voltage (control stages 2, 3) for the adjusted intermediate frequency filter stages (10, 20, 30) is influenced in the frequency response in such a way that the frequency components approximately above 6 kHz are slightly lowered, and
- the control voltage of the second and third phase modulator (6, 7) is influenced in the frequency response in such a way that the high frequency components approximately from 5 kHz are slightly raised.

11. Arrangement according to one of Claims 5 to 10, characterised in that within the intermediate frequency filter a second filter branch bridging the second and optionally further filter stages (20, 30) is provided with a switch (90) which is switched on or off as a function of the output signal of the circuit (100) whereof the output signal forms a measurement for the reception quality.

12. Arrangement according to Claim 11, characterised in that the first and the second filter branch open into an addition stage (40) which is arranged before the demodulator (5) and in which the signals running through it are added up.

## Revendications

1. Dispositif de filtrage d'un signal de réception modulé en fréquence, en particulier dans le cas d'une réception mobile, dans lequel la fréquence moyenne d'un filtre à fréquence intermédiaire à bande relativement étroite par rapport à la largeur de bande du canal est filtrée directement continûment en fonction de la modulation, caractérisé en ce que la forme de la courbe de transmission du filtre à fréquence intermédiaire piloté (1) est variable, dans lequel la bande passante est réduite lorsque la qualité du signal décroît, en fonction d'un circuit (100), dont le signal de sortie constitue une mesure pour la qualité de la réception, une première dérivation du filtre à fréquence intermédiaire (1) étant parcourue en permanence par le signal de réception modulé en fréquence.

2. Dispositif selon la revendication 1, caractérisé en ce que, pour la qualité de la réception, une valeur limite est prescrite, pour le franchissement vers le bas de laquelle, la bande passante est réduite.

3. Dispositif selon la revendication 1, caractérisé en ce que le circuit dont le signal de sortie constitue une mesure pour la qualité de la réception, est formé par un circuit de reconnaissance du canal adjacent.

4. Dispositif selon la revendication 3, caractérisé en ce que le circuit de reconnaissance du canal adjacent est un montage série comportant les étages suivants :
- un premier démodulateur de courbe enveloppe (101) auquel est appliqué le signal de sortie modulé en amplitude par interférence entre le canal utile et le canal adjacent du premier étage de filtre (10) ;
- un filtre passe-haut et/ou bas (102), qui sépare le signal d'interférence démodulé à la sortie du premier démodulateur de courbe enveloppe (101) de parties de signal à fréquence élevée ou basse ;
- un second démodulateur de courbe enveloppe (103), qui forme la courbe enveloppe au moyen du signal d'interférence démodulé, filtré passe-haut, dont le niveau constitue une mesure pour le niveau de la porteuse du canal adjacent; et
- un étage de valeur de seuil-commutation (105), qui compare le signal de courbe enveloppe éventuellement filtré (étage de filtrage 104) à un niveau de référence prescrit et délivre un signal de commutation dans le cas du dépassement du niveau de référence.

5. Dispositif selon l'une des revendications précédentes, caractérisé en ce que le filtre à fréquence intermédiaire piloté (1) comporte au moins deux étages de filtre disposés en succession (10, 20, 30), les signaux de sortie de deux étages de filtre (10) pouvant être combinés par addition et le signal combiné présentant une bande passante plus large étant appliqué à un étage de démodulation en aval.

6. Dispositif selon la revendication 5, caractérisé en ce qu'il s'agit dans au moins un des étages de filtre, dont le signal de sortie peut être combiné par addition, d'un filtre de bande à caractéristique de transmission relativement large.

7. Dispositif selon la revendication 5, caractérisé en ce qu'il s'agit dans au moins un des étages de filtre, dont le signal de sortie peut être combiné par addition, d'un filtre à circuit unique à caractéristique de transmission relativement étroite.

8. Dispositif selon la revendication 7, caractérisé en ce que deux filtres à circuit unique accordés sur la même fréquence, disposés en succession, sont prévus.

9. Récepteur FM équipé d'un dispositif prévu en tant que filtre à fréquence intermédiaire selon la revendication 1, d'un démodulateur disposé en aval du filtre à fréquence intermédiaire, caractérisé en ce qu'en aval du démodulateur (50) est disposé un étage de correction (110), qui est réalisé de sorte que les différentes allures de phases et niveaux résultant des différents temps de transit de groupe et niveaux des étages de filtre combinés par addition sont compensés dans la plage de fréquence inférieure.

10. Récepteur FM selon la revendication 9, caractérisé en ce que
- la tension de commande (étages de commande 2, 3) pour les étages de filtre à fréquence intermédiaire pilotés (10, 20, 30) est asservie en excursion de fréquence, de sorte que les composantes de fréquence sont abaissées légèrement au-dessus de 6 kHz ; et
- la tension de commande des second et troisième modulateurs de phases (6, 7) est asservie en excursion de fréquence de sorte que les composantes de fréquence élevées sont élevées légèrement environ à partir de 5 kHz.

11. Dispositif selon l'une des revendications 5 à 10, caractérisé en ce qu'à l'intérieur du filtre à fréquence intermédiaire est prévue une seconde dérivation de filtre shuntant le second et éventuellement d'autres étages de filtre présents (20, 30) équipée d'un commutateur (90), qui est mis en ou hors circuit en fonction du signal de sortie du circuit (100), dont le signal de sortie constitue une mesure pour la qualité de la réception.

12. Dispositif selon la revendication 11, caractérisé en ce que la première et la seconde dérivation de filtre débouchent dans un étage d'addition (40) disposé en amont du démodulateur (50), dans lequel les signaux les traversant sont additionnés.
